Europäisches Patentamt

European Patent Office

Office européen des brevets

(11) Publication number: **0 201 858**
**A2**

# (12) EUROPEAN PATENT APPLICATION

(21) Application number: 86106224.8

(22) Date of filing: 06.05.86

(51) Int. Cl.⁴: **H 01 J 37/304**
**H 01 J 37/317, H 01 J 37/20**

(30) Priority: 06.05.85 US 730608

(43) Date of publication of application:
20.11.86 Bulletin 86/47

(84) Designated Contracting States:
DE GB NL

(71) Applicant: THE PERKIN-ELMER CORPORATION
761 Main Avenue
Norwalk Connecticut 06859-0074(US)

(72) Inventor: Wiesner, John C.
16978 Hinton Drive
Castro Valley California 94546(US)

(72) Inventor: Cavan, Daniel L.
7 Orchard Hill Road
Woodside California 94062(US)

(74) Representative: Patentanwälte Grünecker, Kinkeldey,
Stockmair & Partner
Maximilianstrasse 58
D-8000 München 22(DE)

(54) Electron beam substrate height sensor.

(57) Disclosed is a method utilizable in a focused deflected particle beam system for trigonometrically determining workpiece surface height displacement from a previously determined calibration plane by using fiducial marks on the workpiece surface, movement of the mechanical stage holding the workpiece, calibrated electronic drive for beam deflection and beam landing angle information.

FIG. 1

EP 0 201 858 A2

0201858

The Perkin-Elmer Corporation
761 Main Avenue
Norwalk, Connecticut 06859-0074

U. S. A.

ELECTRON BEAM SUBSTRATE HEIGHT SENSOR

This invention relates to a method for determining the height of a workpiece disposed on a movable table or stage in a focused deflected particle beam lithography system.

In focused, deflected particle beam lithography systems, a resist coated workpiece (substrate or wafer), on which a pattern is to be exposed (written), is mounted on a movable stage and writing by the beam is accomplished over the entire workpiece surface by using relatively small scale beam deflections, of the order of one or two millimeters, and by moving the stage in the X and Y directions (in a plane generally perpendicular to the beam) until the entire substrate area is covered by the beam deflections, as necessary.

In order to write the pattern accurately, such systems typically include means for measuring the position of the XY stage and the distance it travels on a given command, beam focusing means, accurate beam deflecting means, the beam signal detecting means for identifying fiducial marks on an appropriate surface (workpiece or stage), means for determining the angle of the deflected beam on the identified mark (beam landing angle $\theta$) and system control subsystem for storing the information obtained by such means.

A "calibration plane" or "Z reference" is also defined by the system to provide a plane of reference to which the front or top surfaces, i.e., the surfaces to be patterned by the beam of workpieces may be compared. The beam deflection means will have been calibrated such that commands to deflect the beam will produce a precisely known amount of beam displacement in this calibration plane. Perfectly flat workpieces will be held or clamped on the movable stage such that they will have their top surfaces to be patterned coincident with the calibration plane, but, on the other hand, if the workpiece holding and clamping mechanism is imperfect and/or if the workpiece is sufficiently warped so as to make it impossible to clamp and hold the workpiece flat in the calibration plane, then the workpiece surface will not lie in the calibration plane. The workpiece surface will not lie in the calibration plane by an amount ($\Delta Z$) which can vary from point-to-point in the X or Y direction. If the particle beam, upon being commanded to be deflected, does not impinge on the workpiece in a perpendicular fashion, then its point of impingement will be at a distance from its point of origin by an amount different from a similar distance measured in the calibration plane. This difference will cause errors to be exposed (written) in the pattern on the workpiece. Lack of knowledge of this $\Delta Z$ prohibits correction of the aforesaid errors. Further, lack of knowledge of $\Delta Z$ leads to blurring of the pattern information because of lack of accurate focus of the beam on the workpiece surface.

It is the purpose of this invention to ascertain the amount of the workpiece surface displacements ($\Delta Z$)

from the calibration plane in particle beam systems, where the beam landing angle $\theta$ is non zero, when the beam is deflected.

The invention which fulfills the foregoing purpose in a particle beam focused deflected lithography system comprises, in one embodiment, the method of focusing the undeflected beam on a fiducial mark on a workpiece surface located on an XY stage, moving the stage a precisely known amount in one direction, storing the stage travel information, focusing the beam on the fiducial mark at this second position, determining the .mount of electronic drive necessary to deflect the beam on the fiducial mark in this second position, storing the electronic drive and using previously determined information about the beam landing angle so that the stage travel information and the electronic drive information together may be used for determining, via trigonometry, the workpiece surface height if the latter is not coincident with a given calibration plane.

In a second embodiment, the use of a calibrated XY stage movement is avoided by using the beam deflection calibration and two or more fiducial marks witinin one deflection distance of each other.

Figure 1 is an elevational view in cross section of part of a stage showing a calibration plane without a workpiece in the stage, and directions X and Z (direction Y is into the plane of the figure),

Figure 2 is an elevational view, like Figure 1, but showing a workpiece clamped in the stage so that top surface of the workpiece is in the calibration plane,

Figure 3 is a partial cross sectional view showing an undeflected focused beam incident on a fiducial mark in the center of the beam deflection field on the calibration surface (or on the workpiece if the latter is in the calibration plane), Figure 4 is a view, like Figure 3, with the stage, calibration surface and mark having been moved a distance $X_1$ but with the beam still undeflected,

Figure 5 shows the beam deflected so as to be positioned on the mark at distance $X_1$ and showing the beam landing angle $\theta$,

Figure 6 shows the undeflected beam positioned on a mark on the workpiece surface which is displaced an unknown amount above the calibration plane,

Figure 7 shows the stage, workpiece and mark having been moved a distance $X_2$,

Figure 8 shows the beam deflected so as to be positioned again on the mark at distance $X_2$,

Figure 9 is a view similar to Figure 6 but showing the workpiece surface displaced below the calibration plane, and

Figure 10 shows another method of calibrating workpiece surface height.

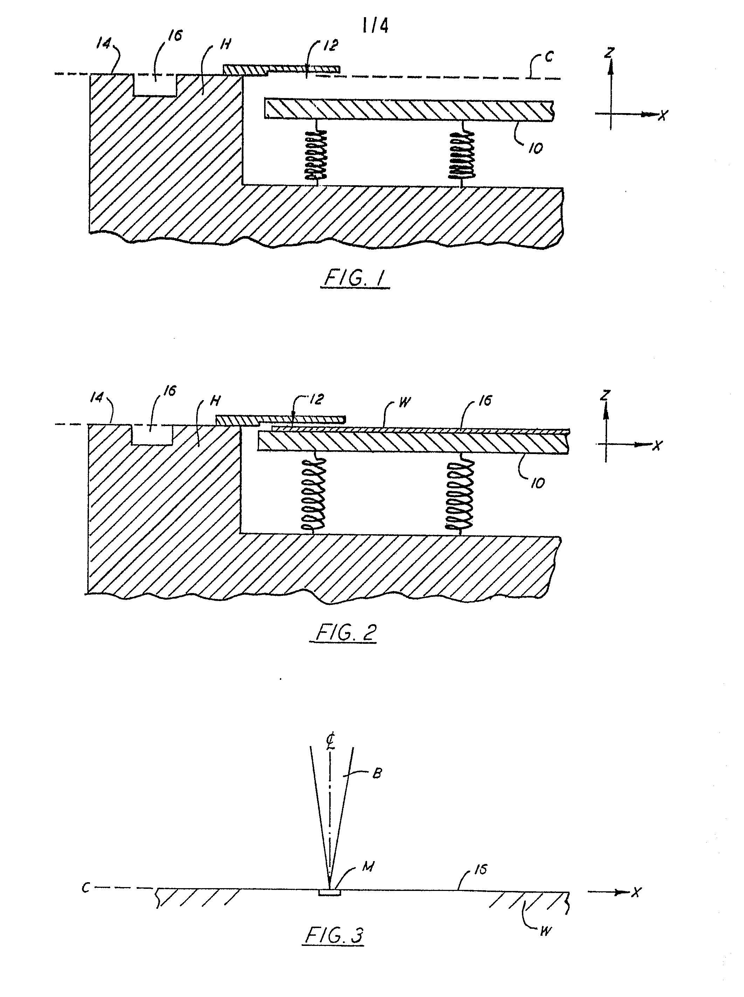

Illustrated in Figure 1 is a cross sectional view of a portion of an empty workpiece holding and clamping mechanism H (sometimes embodied or termed a cassette or a pallet) having a spring loaded workpiece flattening platen 10 for urging a workpiece against a plurality of Z-locating tabs 12, only one of which is shown in Figure 1 and located on the top surface 14 of the cassette. Other means of clamping the workpiece such as electrostatic may also be used. The cassette is mounted on a stage capable of moving in X and Y directions, sometimes called an XY stage, monitored by a laser interferometer.

Typically, the cassette top surface 14 will have a grid, or other means of defining the top surface by use of electrical signals derived from the scanning particle beam. During manufacture and calibration, the cassette fiducial marks and the stage motion will have been adjusted so that the grid, on undergoing motion in the XY plane, via the stage, will define a precise plane, the so-called calibration plane or Z reference, denoted as C. The Z-locating tabs are positioned so that a flat workpiece surface will be in this plane C. See Figure 2, which illustrates the cassette with a workpiece W on the platen with the top surface 16 of the workpiece pressed by the platen against the Z-locating tabs 12, so that surface 16 is in the calibration plane C.

Reference is made to the U.S. Patent No. 3,900,737 to Collier et al disclosing raster scan electron beam lithography system with an XY stage monitored by a laser interferometer and to the U.S. Patent No. 4,412,133 of Eckes et al filed January 1, 1982 showing a cassette with a Z-locating tabs thereon. While the Collier et al patent discloses a raster scan lithography system, this present invention can be practiced in a vector scan lithography system as well.

To simplify the remainder of this description, the workpiece W and top surface 16 and calibration plane C will be shown only schematically, without reference to the cassette, and only the X directional movement will be used to illustrate the invention. The Z direction is taken to be perpendicular to the X direction and to be generally along the beam axis.

Thus, Figure 3 shows a partial cross sectional view of the workpiece with the focused beam B having a center line CL focused on the center of a fiducial mark M in the top surface 16 of workpiece W. Surface 16 is shown accurately located in the calibration plane C. The beam is undeflected in this figure, and impinges perpendicularly on the workpiece.

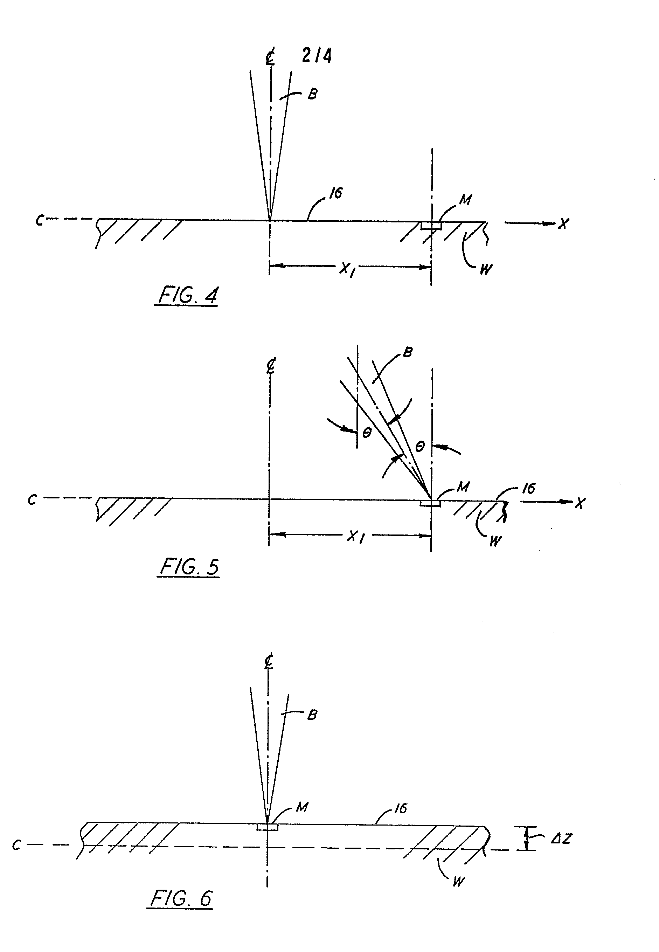

In Figure 4 the beam remains undeflected, as in Figure 3, but the workpiece W and mark M have been moved a distance $X_1$ by movement of the XY stage. The distance

$X_1$ is stored in the system's control subsystem. The distance $X_1$ is chosen to be equal to, but in any case not greater than, the maximum deflection distance of the beam.

In Figure 5 the beam B is deflected so as to be positioned on the mark M. The amount of electronic drive necessary to deflect the beam so as to be positioned on the mark is stored in the system's control subsystem.

Normally, calibration will have been performed, so that a command to move the stage by a distance $X_1$ will produce accurately such motion, while a command to move (deflect) the beam impingement point in the calibration plane by a distance $X_1$ will produce accurately such deflection. Further, during manufacture or primary calibration, the beam landing angle will have been determined as a function of beam deflection. Also, as part of the system's control subsystem, the landing angle $\theta$ for values of X and Y deflection distances are stored. Thus, with distance $X_1$ known, the angle $\theta$ is also known.

As above stated, if the workpiece holding and clamping mechanism H is imperfect and/or if the workpiece is sufficiently warped so as to make it impossible to clamp and be held flat in the calibration plane, then it follows that the workpiece surface will not lie in the calibration plane by an unknown amount $\triangle Z$ (see Figure 6) which can vary from point to point in X or Y directions on the workpiece surface. Lack of knowledge of $\triangle Z$ lead to errors in positioning of the beam on the workpiece surface (if the beam landing angle is not zero) and leads to blurring of the pattern information because of lack of accurate focus of the beam.

As stated before, it is the purpose of this invention to ascertain the workpiece surface displacements, $\triangle Z$, from the calibration plane in particle beam systems where the beam landing angle is non-zero, whenever the beam is deflected.

In Figure 6 the actual workpiece surface 16 is shown to be above the calibration plane.

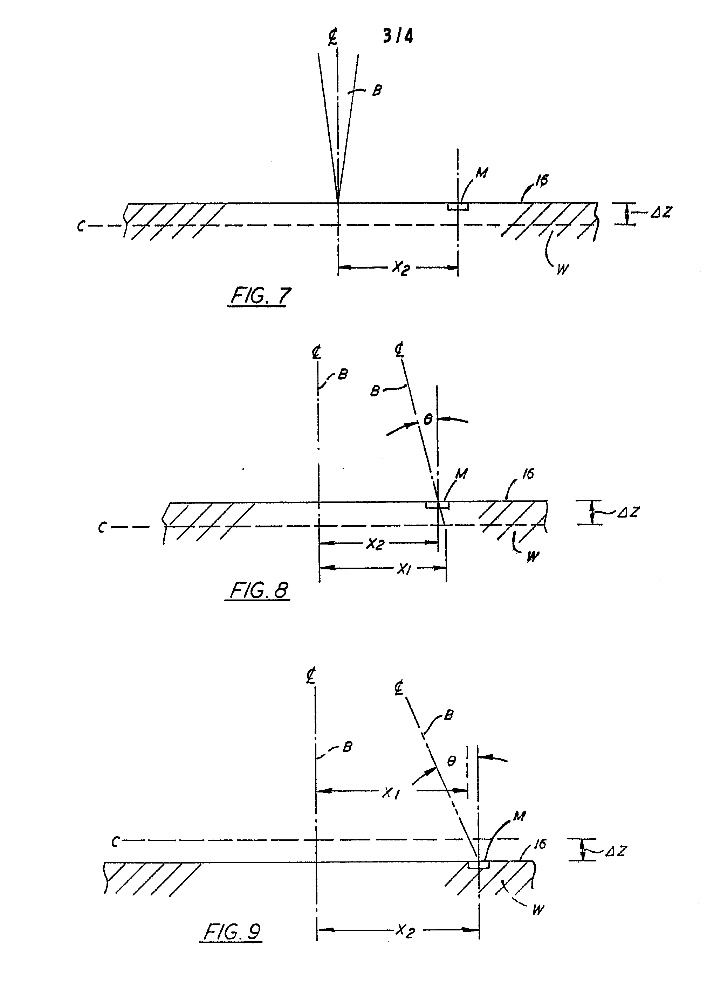

Figure 7 shows the stage having been moved a distance $X_2$ with the workpiece thereon. $X_2$ is chosen to be approximately equal to, but in any event not greater than the maximum calibrated beam deflection distance. Figure 7 also shows the surface 16 still above the calibration plane by an unknown amount $\triangle Z$.

As in Figure 5, Figure 8 shows that the beam is again deflected so as to be positioned on the mark M and, if necessary, the afore-mentioned distance $X_2$ is adjusted by the stage movement to insure that distance $X_2$ is not greater than the maximum calibrated deflection distance.

The amount of electronic deflection drive necessary to locate the mark corresponds to a distance $X_1$ in the calibration plane which is known because of the calibration procedure. Angle $\theta$ is also a known value (corresponding to the deflection drive).

$\triangle Z$ is then determined by trigonometry from the following equation:

$$\triangle Z = (X_1 - X_2) / \tan \theta$$

Figure 9 shows the workpiece displaced below the calibration plane and the same procedure is followed as discussed in Figures 1-8 except the sign of the amount of $\triangle Z$ is reversed. This reversal can be used to determine the direction of displacement of the workpiece surface.

The magnitude of the landing angle $\theta$ is related to the magnitude of the distance disagreement $(X_1 - X_2)$ for a given amount of $\triangle Z$. Larger values of the landing

angle θ require more precise determination of $\triangle Z$ to correct for pattern distortion; but as can be seen from the equation, the determination of $\triangle Z$ is an error in direct relation to the magnitude of angle θ. Larger values of angle θ requiring more precise determination of $\triangle Z$, produce more accurate values for $\triangle Z$.

It should be noted also, that precise positioning of the stage is not required as long as the stage can be positioned sufficiently close to the desired location as to make the variation in angle θ insignificant between locations. Further it is assumed that the values of $\triangle Z$ and angle θ are sufficiently small so as to make variations in angle θ over a beam deflection distance $\left| X_1 - X_2 \right|$ insignificant. Typical values of the parameters are:

θ = 0.01 radian (0.57°) at $X_1$ or $X_2$ which equals 1 or 2 millimeters. $\triangle Z$ for typical situations is found to be 0.01 millimeters or less and thus $\left| X_1 - X_2 \right|$ = 0.0001 millimeters approximately.

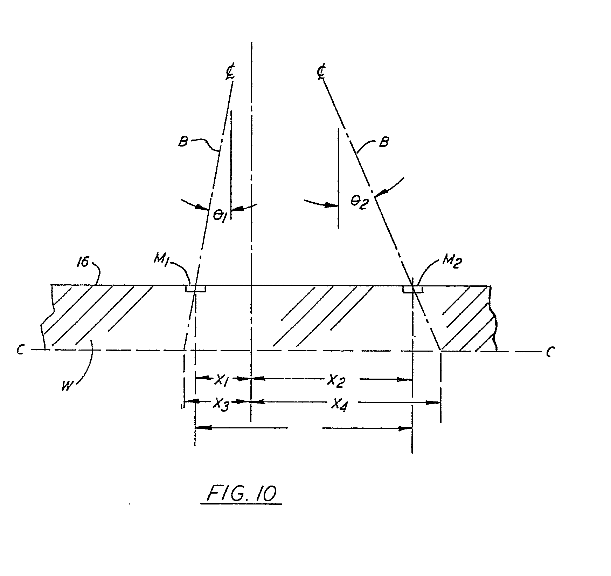

Figure 10 illustrates another embodiment of the invention where workpiece surface displacement is measured from two fiducial marks located within the beam deflection field. In this embodiment, the laser interferometer system is not needed. In this embodiment, it is necessary that the two marks be imprinted on the workpiece surface at a precisely known separation L. Like the first embodiment, the beam deflection system is precisely calibrated such that the beam is made to impringe at known distances in the calibration plane, on command. Further, the beam landing angles are known versus beam deflection amounts. The stage is moved such that $X_1 - X_3$ is negligibly small, by making $X_1$ sufficiently small. Thus, by scanning the fiducial mark $M_1$, the distance $X_1$ is measured. Since the distance L between the mark is known, $X_2$ is derived as $(L=X_1)$ by scanning the second mark $M_2$, its position is

measured as $X_4$ as though it were in the calibration plane. Hence $\triangle Z$ can be determined as $\triangle Z = (X_4 - X_2)$ tan $\theta_2$. Utilizing this information, the amount of $\triangle Z$ is then calibrated by placing the undeflected beam near one mark sufficiently close to the center of the field as to make the measured distance $X_2 - X_3$ negligibly small compared with distances $X_2$ or $X_4$. Hence, $X_2$ is approximately equal to L a known value. The beam measures $X_4$ also a known value, hence, $\triangle Z$ is determined by the formula

$$\triangle Z = (X_4 - X_2) / \tan \theta_2$$

If $X_1$ cannot be made close to zero then several positions and several measurements will yield sufficient data to produce $\triangle Z$, via data reduction.

CLAIMS:

1.  In a particle beam lithographic system having means for focusing and accurately deflecting a particle beam and for accurately moving a stage in a XY plane and having means for coordinating the deflection of the particle beam so as to jointly calibrate the beam deflection and the amount of stage movement and also to determine the angle of beam deflection, the method of determining the height of a workpiece having fiduciary marks on its surface and located on said stage, comprising the steps of,

   placing one fiduciary mark directly beneath the particle beam when the beam is undeflected,

   moving said stage a selected distance to a second location and deflecting said beam until it is focused on said fiduciary mark at this second location,

   storing information as to the amount of beam deflection, and stage movement and angle of beam deflection, and

   using the amount of beam deflection, beam landing angle and stage movement to determine, by means of a trigonometric calculation, the height of a substrate relative to a predetermined calibration plane.

2.  In a particle beam system having means for moving a table in a XY direction and a particle beam deflection means and means for determining the beam landing angle and means for storing information regarding the electronic drive for deflection of the particle beam, the method of determining the height of a workpiece top surface on the table comprising:

   defining a calibration plane,

   establishing the position of the XY table to enable focusing the nearly undeflected particle beam on a fiducial mark in the workpiece top surface, and storing information position of the particle beam;

   deflecting the beam to, and focusing it on, a second mark at a known distance from the first mark,

   storing the information regarding the beam deflection to reach the first and second marks,

determining the height of the workpiece top surface relative to the calibration plane by a knowledge of the distance between the first and second marks, the beam deflection amounts, the related beam landing angles, and trigonometry.

3. In a particle beam system having means for moving a table in a XY direction, a particle beam deflection means, means for determining the beam landing angle, and means for storing information regarding the electronic drive for deflection of the particle beam, the method of determining the height of a workpiece top surface on the table comprising;

defining a calibration plane,

establishing the position of the XY table to enable focusing of the nearly undeflected particle beam on a fiducial mark on the workpiece top surface, and storing information on the position of the particle beam;

deflecting the beam to, and focusing it on, a second mark at a known distance from the first mark;

defining a pluarlity of marks at known distances from the first mark and from one another and using such marks when the stage cannot be commanded precisely to place at least one mark sufficiently close to the position of the undeflected beam to make possible a simple calculation, and

determining a plurality of deflection amounts and related landing angles when said beam is commanded to seek such marks to determine by data reduction the workpiece top surface height relative to the calibration plane.

1/4

FIG. 1

FIG. 2

FIG. 3

2/4

_FIG. 4_

_FIG. 5_

_FIG. 6_

0201858

FIG. 7

FIG. 8

FIG. 9

4/4

<u>FIG. 10</u>